(19) Europäisches Patentamt

European Patent Office

Office européen des brevets

(11) Veröffentlichungsnummer: **0 383 140 B1**

(12) **EUROPÄISCHE PATENTSCHRIFT**

(45) Veröffentlichungstag der Patentschrift: **12.01.94**

(21) Anmeldenummer: **90102229.3**

(22) Anmeldetag: **05.02.90**

(51) Int. Cl.5: **G01R 31/06**, G01R 27/26

(54) **Verfahren und Vorrichtung zur Prüfung von Spulen auf Windungs und/oder Lagenschluss.**

(30) Priorität: **15.02.89 DE 3904553**

(43) Veröffentlichungstag der Anmeldung:
**22.08.90 Patentblatt 90/34**

(45) Bekanntmachung des Hinweises auf die
Patenterteilung:
**12.01.94 Patentblatt 94/02**

(84) Benannte Vertragsstaaten:
**AT CH DE FR GB IT LI SE**

(56) Entgegenhaltungen:
**DE-B- 1 041 154**
**FR-A- 2 365 806**
**GB-A- 2 192 464**

**ELECTRONICS & WIRELESS WORLD, Band
92, Nr. 1610, Dezember 1986, Seiten 61-62,
Sutton, Surrey, GB; R.A. WALDRON: "Novel
O-meter"**

(73) Patentinhaber: **SIEMENS AKTIENGESELL-
SCHAFT**
**Wittelsbacherplatz 2**
**D-80333 München(DE)**

(72) Erfinder: **Trampert, Wolfgang**
**Joh.-Seb.-Bach-Strasse 3**
**D-8523 Baiersdorf(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein Windungs- und/oder Lagenschlußprüfverfahren für Spulen. Daneben bezieht sich die Erfindung auch auf die zugehörige Vorrichtung zur Durchführung des Verfahrens, mit einem Reihenschwingkreis, dessen Bestandteil die zu prüfende Spule (Prüfling) ist, einem Generator zur Erzeugung einer frequenzvariablen Spannung und einem Meßsystem zur Erfassung der Güte von Spulen.

Spulen für elektrotechnische Anwendungen werden heute durchweg in Massenfertigung gewickelt. Da die lackisolierten Wickeldrähte Fehler aufweisen können, ist das Auftreten eines Windungs- oder gar Lagenschlusses nicht ausgeschlossen. Bei der Fertigung unerkannt gebliebene Windungsschlüsse können unter Umständen zu einem Langzeitausfall der Spule führen. Daher ist es notwendig, die fertig gewickelten Spulen im Rahmen der Qualitätssicherung einer Prüfung auf Windungs- und/oder Lagenschluß zu unterziehen, wozu Meßverfahren nach unterschiedlichsten physikalischen Prinzipien möglich sind.

In der Praxis sind bisher Meßverfahren üblich, die beispielsweise nach dem Prinzip einer Wechselspannungsmeßbrücke oder nach dem Stoßspannungsprüfverfahren arbeiten. Nach diesem Prinzip realisierte Meßgeräte arbeiten bei Spulen mit geringeren Windungszahlen zufriedenstellend. Bei Spulen höherer Windungszahl liefern die bekannten Geräte aber aufgrund der parasitären Spulenkapazität bzw. wegen des geringen Durchmessers des Wickeldrahtes keine sicheren Ergebnisse mehr.

Aufgrund immer höher werdender Anforderungen an die Spulen sollen Windungsschlüsse über eine Windung, insbesondere auch bei Spulen mit sehr hohen Windungszahlen, sicher erkannt werden. Dabei soll das Meßverfahren derart ausgelegt sein, daß es für den Einsatz bei einer flexiblen Massenfertigung von Spulen geeignet ist.

Mit der DE-C-910 092 und der DE-B-26 44 253 wurden bereits Verfahren und Vorrichtung zur Prüfung von Spulen auf Windungs- und/oder Lagenschluß vorgeschlagen, bei denen die zu prüfende Spule auf Schenkelkerne aufgeschoben wird und die magnetische Induktion in Kurzschlußwicklungen von fehlerhaften Spulen zur Messung ausgenutzt wird. Als wesentlicher Vorteil wird dort angesehen, daß die Spulen nicht kontaktiert werden müssen. In vielen Fällen ist aber in der Praxis im Rahmen der Qualitätssicherung, beispielsweise für die Messung des Kupferwiderstandes, eine Kontaktierung der Spulenanschlüsse notwendig und daher ohnehin in die Prüfung eingeschlossen. Aus der GB-A-21 92 464 ist eine diesbezügliche Anordnung zum Testen von Spulenbauteilen bekannt, bei der ein Bauteil in einer Kontaktiereinrichtung über eine Schaltmatrix alternativ an eine Meßvorrichtung für den induktiven und ohmschen Widerstand, an einen Isolationstester und an ein Spannungsmeßgerät anschließbar ist und die Meßsignale computergestützt ausgewertet werden. Es kann auch die Güte einer Spule gemessen werden.

Aufgabe der Erfindung ist es demgegegenüber, ein weiteres Verfahren mit der zugehörigen Vorrichtung anzugeben, mit denen eine Wicklungsprüfung problemlos erfolgen kann.

Die Aufgabe ist erfindungsgemäß bei einem Verfahren der eingangs genannten Art durch folgende Merkmale gelöst:

- die Spule wird als Induktivität und Widerstand in einen Reihenschwingkreis geschaltet,
- es wird eine Gütemessung der Spule durch Erfassung der Spannungsüberhöhung bei Resonanz des Schwingkreises durchgeführt,
- durch Auswahl einer geeigneten Kapazität wird im Reihenschwingkreis die Resonanzfrequenz in einen solchen Bereich gelegt wird, in dem die Spulengüte ihr Maximum erreicht,
- der erfaßte Gütenmeßwert der Spule wird mit einem Sollwert verglichen und bei Abweichen eines vorbestimmbaren Toleranzwertes wird ein Signal für den Windungsschluß abgegeben

Im Rahmen der Erfindung konnte gezeigt werden, daß die Messung der Spulengüte sich bei Beachtung obiger Randbedingungen zur Windungsschlußerkennung eignet, da insbesondere der Einfluß von Toleranzabweichungen des Windungswiderstandes auf den Gütefaktor kompensiert ist.

Messungen des Spulengütefaktors sind an sich bekannt, wozu auf den diesbezüglichen Stand der Technik gewiesen wird. Ein Gerät zur Messung der Spulengüte wird beispielsweise in der Zeitschrift "Electronics & Wireless World" 92 (1986), Dez., No. 16/0, Seite 61 angegeben. Die erfindungsgemäße Lehre ist damit aber nicht angesprochen. Die Anwendung des erfindungsgemäßen Verfahrens ist daher immer dann sinnvoll, wenn der Windungswiderstand ohnehin gemessen wird, wozu die Spulenanschlüsse zu kontaktieren sind. Der Windungswiderstand fällt auch bei der Gütemessung an, so daß die benötigten Handhabungs- und Meßzeiten für eine gemeinsame Messung optimiert werden können.

Wesentlich ist bei der Erfindung, daß durch geeignete Wahl eines Kondensators die Meßfrequenz in einen Bereich gelegt wird, in dem die Spulengüte ihr Maximum erreicht. Somit wird bei variabler Frequenz in einem prüflingsspezifischen Frequenzbereich gemessen, so daß zumindest bei Spulen mit Windungszahlen bis zu 17.000 Wdg bei Kurzschluß einer einzigen Windung ein hinreichend spezifisches Signal erreicht wird. Dabei kann bei weit variierenden Meßfrequenzen - beispielsweise im Bereich zwischen 500 Hz und

2

100 kHz - gemessen werden. Durch Vergleich des bei der geeigneten Meßfrequenz ermittelten Gütemeßwertes des Prüflings mit einer vorher aufgenommenen Güte einer Normalspule kann bei Abweichen des Meßwertes von einem vorbestimmbaren Toleranzwert ein Fehlersignal für den Windungsschluß abgegeben werden.

Bei einer Vorrichtung zur Durchführung des Verfahrens mit einem Reihenschwingkreis, deren Bestandteil die zu prüfende Spule ist und die ein an sich bekanntes Meßsystem zur Erfassung der Güte von Spulen aufweist, sind Mittel zur automatischen Auswahl einer geeigneten Kapazität im Reihenschwingkreis, bei dem die Resonanzfrequenz in einem solchen Bereich liegt, in dem die Spulengüte ihr Maximum hat, vorhanden. Vorzugsweise ist das Meßsystem kapazitätsarm an den Schwingkreis angekoppelt und wird mit dem Meßsystem die Spannungsüberhöhung am Kondensator des Schwingkreises gemessen.

Vorzugsweise ist der frequenzvariable Generator niederohmig am Schwingkreis angeschlossen.

Vorteilhaft ist bei der Erfindung, daß sich durch geeignete Ausbildung des Meßsystems der Prüfvorgang automatisieren läßt. Insbesondere die Auswahl der geeigneten Kapazitäten für die Resonanz im Reihenschwingkreis erfolgt vollautomatisch durch entsprechende software-mäßige Ausgestaltung mittels eines Personal-Computers

Es hat sich gezeigt, daß es mit dem erfindungsgemäßen Verfahren und der zugehörigen Vorrichtung möglich ist, Windungsschlüsse über eine einzige Windung auch noch bei Spulen mit bis zu 17.000 Wdg sicher zu erkennen. Dabei beträgt die erforderliche Prüfzeit ca. 3,5 s. In dieser Zeit ist die Messung des temperaturkompensierten Widerstandswertes bereits enthalten. In Abhängigkeit von der Prüfschärfe und geeigneter Wahl des gleichermaßen für die Auswertung verwendeten Personal-Computers läßt sich die Prüfzeit bis auf etwa 1,5 s vermindern.

Weitere Einzelheiten und Vorteile der Erfindung ergeben sich aus der nachfolgenden Figurenbeschreibung von Ausführungsbeispielen in Verbindung mit den weiteren Unteransprüchen. Es zeigen

FIG 1 ein elektrisches Ersatzschaltbild der Prüfvorrichtung,

FIG 2 und 3 Diagramme zur Erläuterung der Wahl der Meßfrequenz,

FIG 4 einen Ausschnitt aus FIG 3 für einen konkreten Spulentyp,

FIG 5 das Gesamtmeßsystem mit einem Personalcomputer zur Ablaufsteuerung der Messung und Auswertung der Meßdaten,

FIG 6 ein Flußdiagramm zur Verdeutlichung der vollautomatischen Ermittlung der Meßparameter und

FIG 7 ein Flußdiagramm zur Verdeutlichung der Serienprüfung.

Das hier vorgeschlagene Verfahren beruht auf einem modifizierten Gütemeßverfahren für Spulen. Zur Bestimmung der Güte der Spule wird der Prüfling als Induktivität in einen Reihenschwingkreis mit einer Kapazität geschaltet. Die Kreisgüte des Schwingkreises wird durch die Güte des Kondensators einerseits und der Spule andererseits bestimmt. Da die Spulengüte sehr viel kleiner ist als die Güte des Kondensators, kann die Messung der Spulengüte auf die Messung der Schwingkreisgüte zurückgeführt werden. Somit läßt sich die Spulengüte allein durch Messung der Spannungsüberhöhung bei dem in Resonanz befindlichen Reihenschwingkreis bestimmen.

Zum Verständnis der Meßschaltung werden zunächst die verwendeten Begriffe erläutert:

In einem Reihenschwingkreis mit Spule und Kondensator erreichen die Beträge der Spannungen an der Spule und am Kondensator in Abhängigkeit von der Frequenz ihr Maximum in der Nähe der Resonanzfre-quenz. Es gilt allgemein

$$(1) \quad |U_L| = |U_C| = U_o \cdot Q$$

Die sogenannte Kreisgüte Q läßt sich auch als der Wert des elektrischen Verlustfaktors $\delta$ darstellen, der sich in einem Reihenschwingkreis aus der Summe der Verlustfaktoren von Spule ($\delta_L$) und Kondensator ($\delta_C$) berechnet. Es gilt:

$$(2) \quad Q = \frac{1}{\tan \delta_L + \tan \delta_C} = \frac{1}{\tan \delta \, ges}$$

Da der Verlustfaktor der verwendeten Kondensatoren um mehr als eine Zehnerpotenz kleiner ist als der der Prüflingsspulen, läßt sich die Kreisgüte Q für praktische Zwecke ausschließlich durch die Güte der Spule darstellen. Dabei ist die Güte der Spule im wesentlichen abhängig vom Widerstand der Spule ($R_{Cu}$) und von den Wirbelstromverlusten ($R_W$). Es gilt

(3)     $\tan \delta_L = \tan \delta_{Cu} + \tan \delta_W$

$$(3.1) \quad \tan \delta_L = \frac{R_{Cu}}{\omega \cdot L} + \frac{R_W}{\omega \cdot L}$$

Ein Windungsschluß führt zu einer Vergrößerung von $R_W$ und damit zu einer Verminderung von Q. Wenn man den temperaturabhängigen und toleranzbehafteten Widerstand von Kupferdrähten kompensiert, kann über die Messung der Güte ein Windungsschluß erkannt werden.

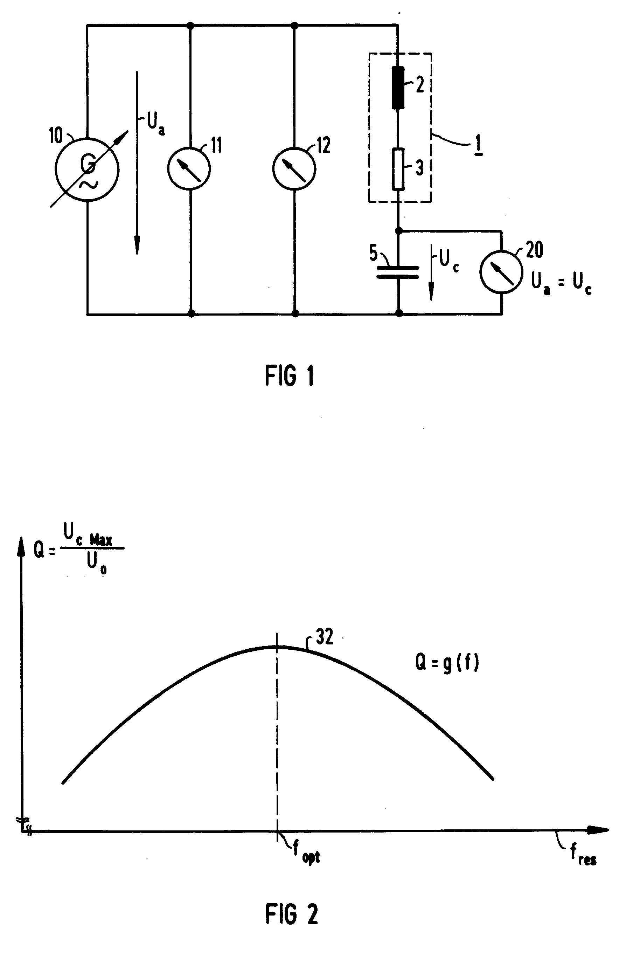

Bei der schematischen Meßschaltung gemäß FIG 1 mit Prüfling 1 stellt 2 dessen Induktivität und 3 dessen ohmschen Widerstandsanteil dar. Dem Prüfling ist in Reihe ein Kondensator 5 mit der Kapazität C geschaltet. Der Resonanzkreis aus Spule 1 und Kondensator 5 wird von einem frequenzselektiven Generator 10 erregt. Die Meßfrequenz f und die Spannung $U_o$ werden über entsprechende Meßgeräte 11 und 12 parallel abgegriffen. Die im Resonanzfall entstehende Spannungsüberhöhung wird speziell am Kondensator 5 abgegriffen und mit einem Präzisionsmeßgerät 20 gemessen.

Nachfolgend wird dargestellt, daß die Messung der Kreisgüte auf die Messung der Spannungsüberhöhung am Kondensator 5 zurückgeführt werden kann. Für die Spannung am Kondensator gilt entsprechend den bekannten Beziehungen der Elektrotechnik folgender Ausdruck:

$$(4) \quad |U_C| = |U_o| \cdot \frac{1}{\sqrt{(\omega \cdot C \cdot R)^2 + (1 - \omega^2 \cdot L \cdot C)^2}}$$

Aus Gleichung (4) läßt sich durch Differentiaton die Frequenz für die maximale Spannung am Kondensator 5 bestimmen:

$$(5) \quad \omega_{U_C} = 2 \pi f = \omega_o \cdot \sqrt{1 - \frac{1}{2Q^2}} \quad \text{mit} \quad \omega_o = \frac{1}{\sqrt{L \cdot C}}$$

Die Höhe des Maximums der Spannung bei der Frequenz gemäß Gleichung (5) ergibt sich so zu:

$$(6) \quad \left|\frac{U_{c\,Max}}{U_o}\right| = \frac{Q}{\sqrt{1 - \frac{1}{4 \cdot Q^2}}} \approx Q$$

Da die Wurzel unter dem Bruchstrich für Q>5 vernachlässigt werden kann, ergibt sich der gleiche Ausdruck wie in Gleichung (1). Damit ist belegt, daß die Messung der Kreisgüte, und damit auch der Spulengüte, allein durch die Erfassung der Spannungsüberhöhung am Kondensator 5 im Ersatzschaltbild gemäß FIG 1 erfolgen kann.

In FIG 2 wird die Frequenzabhängigkeit der Spulengüte verdeutlicht: Aufgetragen ist in willkürlichen Einheiten die Spulengüte Q als Ordinate in Abhängigkeit von der Resonanzfrequenz f als Abszisse. Man erkennt, daß das Signal Q = g(f) entsprechend Graph 32 mit der Frequenz variiert und bei einem bestimmten Wert ein deutliches Maximum durchläuft. Diese Frequenz $f_{opt}$ ist vom Prüflingstyp abhängig und kann im Bereich zwischen 500 Hz und 100 kHz liegen.

Es läßt sich zeigen, daß der Wert der Verminderung der Spulengüte durch Auftreten eines Windungsschlusses bei $f_{opt}$ maximalist. Hier ist also die Spezifität für die Anzeige eines Windungs- und/oder Lagenschlusses am größten. Daher wird bei dieser optimalen Frequenz gemessen und hierfür aus einer Vielzahl von parallelgeschalteten Kapazitäten eine optimale angepaßte Kapazität an den Schwingkreis mit vorgegebenem Prüfling angeschaltet.

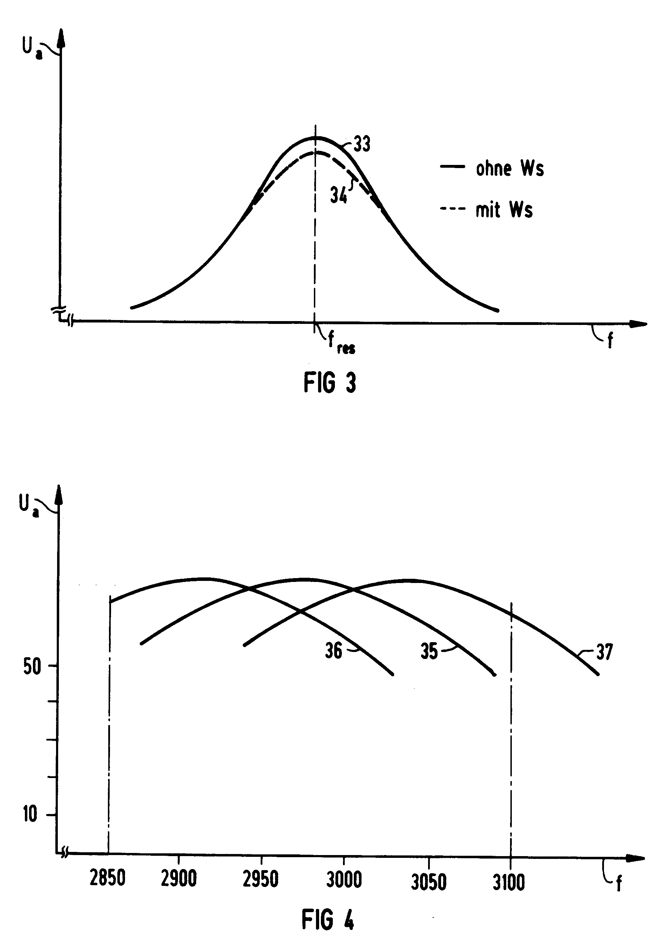

In FIG 3 ist der qualitative Verlauf der am Kondensator gemessenen Spannung $U_C$ im Reihenschwingkreis in Abhängigkeit von der Frequenz dargestellt. Durch Auswahl eines geeigneten Kondensators wurde dafür gesorgt, daß die Frequenz $f_{opt}$ aus FIG 2 mit der Frequenz $f_{res}$ übereinstimmt. Der Graph 33 zeigt die Funktion $U_c = h(g)$ bei einer Spule ohne Windungsschluß, der Graph 34 dagegen die gleiche Funktion bei einer Spule mit Windungsschluß. Es ergibt sich also ein eindeutig identifizierbares Signal.

Theoretischen Betrachtungen ist zu entnehmen, daß bei einer beliebigen Spule als Prüfling in Abhängigkeit von deren Induktivität L und Kapazität $C_L$ eine Verschiebung der Kurve 33 gemäß FIG 3 auftreten kann. FIG 4 zeigt einen Ausschnitt aus FIG 3 in Anwendung einer Spule vom Typ 3 Tj 2 mit einer Windungszahl von n = 17.000. Beispielsweise liegt hier das Maximum der Normalspule bei etwa f = 2970 Hz entsprechend Graph 35. Wird L oder $C_L$ größer, verschiebt sich f zu niedrigeren Frequenzen entsprechend Graph 36; wird L oder $C_L$ kleiner, verschiebt sich f dagegen zu höheren Frequenzen entsprechend Graph 37, wobei aber in beiden Fällen der Absolutwert des Maximums auf der gleichen Höhe wie bei Graph 35 bleibt. Durch einen Lagen- und/oder Windungsschluß ändert sich dagegen auch der Absolutwert der Spannung im Maximum entsprechend Graph 34 aus FIG 3.

Die Graphen 36 und 37 in FIG 4 stellen Grenzwerte für die minimale bzw. maximale Induktivität und/oder Kapazität dar. Alle in der Praxis vorkommenden Spulen des genannten Typs liegen im Bereich dieser Grenzkurven. Der für das konkrete Beispiel angepaßte Meßfrequenzbereich reicht also von etwa 2850 bis 3100 Hz.

Für eine Serienprüfung muß zunächst einmalig an einer Normalspule, die dem Prüflingstyp nahekommt, die optimale Meßfrequenz ermittelt werden. Bei der Serienprüfung wird dann die Meßfrequenz variiert, gleichzeitig die Spannung am Kondensator gemessen und jeweils der Wert der maximalen Spannung ausgewertet. Im optimalen Meßbereich kann dann der Absolutwert des Maximums der Spannung und damit auch der Güte eindeutig anzeigen, ob ein Windungsschluß vorliegt oder nicht.

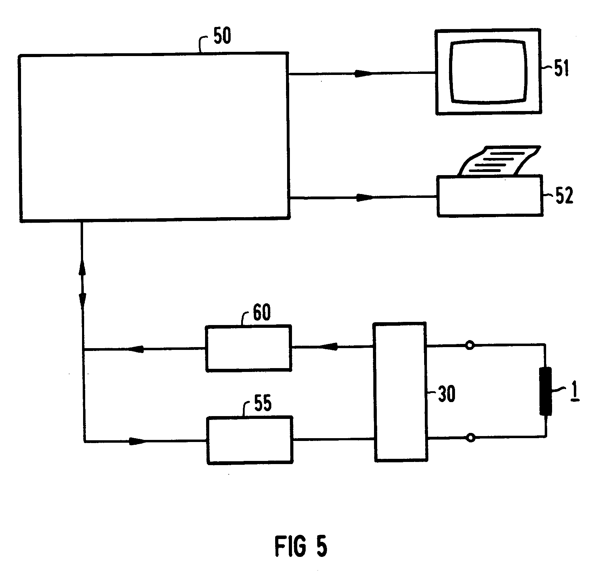

In FIG 5 ist eine Meßeinrichtung gemäß FIG 1 in ein Meßsystem eingebunden, das im wesentlichen aus einem Personalcomputer (PC) 50 mit zugehörigen Endgeräten, wie einen Monitor 51 und einen Drucker 52, sowie einem frequenzvariablen Oszillator 55 und einem Digitalmultimeter 60 besteht. Der Oszillator 55 dient zur Synthetisierung von frequenzvariablen Spannungen und wird beim Meßablauf durch den PC 50 gesteuert. Weiterhin ist eine Anpaßeinheit 30 vorhanden, die eine niederohmige Ankopplung des Generators 55 an den Schwingkreis und die kapazitätsarme Auskopplung des Meßsignals ermöglicht. In der Praxis werden zu diesem Zweck Trennverstärker benutzt.

Durch geeignete software-mäßige Vorgabe wird der Prüfablauf in der Weise gesteuert, daß die optimalen Meßparameter selbsttätig aufgefunden und an den angeschlossenen Geräten eingestellt werden. Nach dem Start der Messung übernimmt der PC 50 die Aufnahme und Auswertung der Meßwerte und bringt das Endergebnis schließlich zur Anzeige. Neben der Verarbeitung der Meßwerte kann mit dem PC 50 insbesondere eine Speicherung der vorgegebenen Sollwerte erfolgen. Zusätzlich ist für die Anwendung bei der Massenfertigung eine statistische Auswertung der Meßwerte möglich.

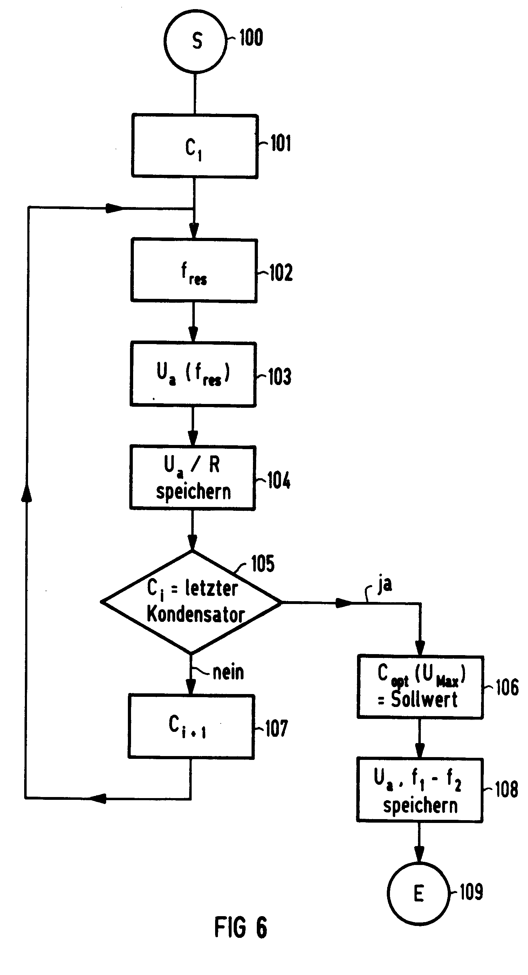

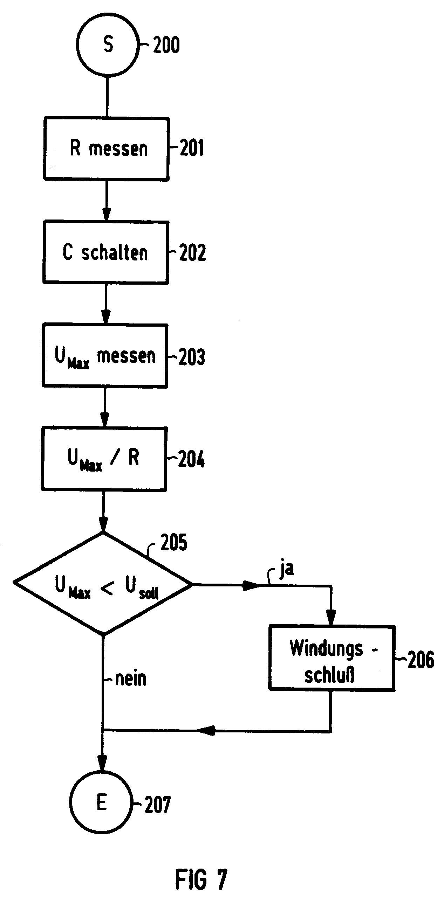

Die Windungsschlußprüfung ist entsprechend den Flußdiagrammen gemäß FIG 6 und FIG 7 dargestellt. Dabei zeigt FIG 6 die einmalige und automatische Ermittlung der optimalen Meßparameter, dagegen FIG 6 die eigentliche Meßsequenz, die für jeden Prüfling bei der Serienprüfung durchgeführt wird. Dabei sind entsprechend üblicher Praxis Ablaufschritte mit Rechtecken und Entscheidungsschritte mit Rauten gekennzeichnet.

Die Darstellung in FIG 6 geht von der Annahme aus, daß die Resonanzfrequenz des aus der selektiv zuschaltbarem Kapazität und der Prüflingsinduktivität gebildeten Reihenschwingkreises im Frequenzbereich zwischen beispielsweise 500 Hz und 100 kHz liegt. Nach dem Start gemäß Position 100 wird in dem Ablaufschritt 101 der este Kondensator $C_1$ angewählt und anschließend für den mit diesem Kondensator $C_1$ bestückten Schwingkreis die Resonanzfrequenz gesucht. Die maximale Spannung U wird im Ablaufschritt 103 ermittelt. Im Ablaufschritt 104 wird die gemessene Spannung $U_a$ auf den Nennwiderstand bezogen und abgespeichert.

Im Entscheidungsschritt 105 wird geprüft, welcher der Kondensatoren mit den zur Verfügung stehenden Kapazitäten $C_i$ angewählt wurde. Ist der letzte Kondensator angewählt gewesen, wird gemäß Ablaufschritt der optimale Kondensator durch Auswertung der gemessenen Spannung ermittelt und als Sollwert übernommen. Ist dagegen nicht der letzte Kondensator angewählt gewesen, wird gemäß Ablaufschritt 107 der nächste Kondensator $C_i$ angewählt, zur Position 102 zurückgegangen und eine entsprechende Schleife durchlaufen.

Mit obiger Prozedur kann aus den zur Verfügung stehenden Kondensatoren mit Kapazitäten $C_I$ die optimale Kapazität, bei der ein Maximum der Spulengüte vorliegt, ermittelt werden. Die bei diesem Kondensator gemessene Spannung U und der Frequenzbereich f1 bis f2 wird gemäß Ablaufschritt 108 dann als Sollwerte abgespeichert. Bei Position 109 ist die Teilsequenz zur einmaligen Ermittlung der Meßparameter für einen Prüfling beendet.

In der Meßsequenz gemäß FIG 7 wird mit Position 200 gestartet und beim Ablaufschritt 201 zunächst der Windungswiderstand gemessen. Bei Position 202 wird der für diesen Prüflingstyp ermittelte Kondensator mit Kapazität $C_i$ in den Reihenschwingkreis geschaltet und bei Ablaufschritt 202 der Reihenschwingkreis erregt und dabei die maximale Spannung ermittelt. Diese Spannung wird gemäß Ablaufschritt 203 auf den Nennwiderstand bezogen. Im Entscheidungsschritt 205 wird geprüft, ob die ermittelte Spannung und damit auch die Güte des Prüflings im Toleranzbereich liegt, wofür der Wert der maximalen Spannung mit dem vorgegebenen Sollwert verglichen wird. Ist der Meßwert kleiner als der Sollwert wird gemäß Position 206 ein Windungsschluß festgestellt. Bei 207 wird die Messung beendet.

Eine Serienprüfung von Spulen nach den Flußdiagrammen gemäß FIG 6 und 7 kann in verschiedener Hinsicht modifiziert werden, was durch Software-Änderungen ohne weiteres möglich ist. In jedem Fall kann der Benutzer der erfindungsgemäßen Vorrichtung am Monitor 51 des PC 50 unmittelbar eine Aussage über die Qualität der Spule und das eventuelle Vorliegen eines Windungsschlusses erhalten.

Durch die vollautomatisierte Messung kann die Serienprüfung auch von ungeschultem Personal einwandfrei durchgeführt werden. Obwohl die unvermeidbaren Fertigungstoleranzen der Prüflingsspulen keinen Einfluß auf das Meßergebnis haben und jeder Prüfling bei den für ihn optimalen Meßparametern geprüft wird, ist die Meßzeit kurz. Da im Rahmen der Windungsschlußprüfung die Temperatur und der Windungswiderstand ohnehin gemessen werden, kann auf eine eventuell notwendige gesonderte Messung dieser Größen verzichtet werden. Dadurch können die benötigten Handhabungs- und Prüfzeiten optimiert werden.

Da ein PC zur Prüfablaufsteuerung verwendet wird, können alle anfallenden Meßwerte leicht einer statistischen Auswertung unterzogen werden.

**Patentansprüche**

1. Windungs- und/oder Lagenschlußprüfverfahren für Spulen, **gekennzeichnet** durch folgende Merkmale:
   - die Spule (1) wird als Induktivität (2) und Widerstand (3) in einen Reihenschwingkreis (1,5) geschaltet,
   - es wird eine Gütemessung der Spule durch Messung der Spannungsüberhöhung bei Resonanz des Schwingkreises durchgeführt,
   - durch Auswahl einer geeigneten Kapazität (5) im Reihenschwingkreis wird die Resonanzfrequenz ($f_{res}$)in einen solchen Bereich gelegt, in dem die Spulengüte (Q) ihr Maximum erreicht,
   - der erfaßte Gütemeßwert der Spule wird mit einem Sollwert verglichen wird und bei Abweichen eines vorbestimmbaren Toleranzwertes wird ein Signal für den Windungsschluß abgegeben.

2. Verfahren nach Anspruch 1, **dadurch gekennzeichnet,** daß bei der Messung die Erregerfrequenz für den Schwingkreis verändert und jeweils die Spannung bei dieser Frequenz erfaßt wird.

3. Verfahren nach Anspruch 1 oder 2, **dadurch gekennzeichnet,** daß die optimale Meßfrequenz, die innerhalb eines prüflingsabhängigen Meßfrequenzbereiches liegt, mit Hilfe einer Normalspule, die dem Prüflingstyp nahekommt, ermittelt wird.

4. Verfahren nach Anspruch 1 oder 2, **dadurch gekennzeichnet,** daß die Meßfrequenz variiert und jeweils die Kreisgüte bestimmt wird und daß der Wert der Güte ausgewertet wird.

5. Verfahren nach Anspruch 3 und 4, **dadurch gekennzeichnet,** daß der erfaßte Gütemeßwert des Prüflings mit einer vorher aufgenommenen Güte einer Normalspule verglichen wird und bei Abweichen eines vorbestimmbaren Toleranzwertes ein Signal für den Windungsschluß abgegeben wird.

6. Verfahren nach Anspruch 1, **dadurch gekennzeichnet,** daß neben der Güte gleichermaßen der Windungswiderstand der Spule gemessen wird.

7. Verfahren nach Anspruch 6, **dadurch gekennzeichnet,** daß der Meßwert der Güte auf den Windungswiderstand bezogen wird.

8. Verfahren nach Anspruch 3, **dadurch gekennzeichnet,** daß der Meßfrequenzbereich aus einem Frequenzspektrum zwischen etwa 500 Hz und etwa 100 kHz ermittelt wird.

**9.** Vorrichtung zur Durchführung des Windungs- und/oder Lagenschlußprüfverfahrens nach Anspruch 1 oder einem der Ansprüche 2 bis 8, mit einem Reihenschwingkreis (1, 5), dessen Bestandteil die zu prüfende Spule (Prüfling 1) und ein Kondensator (5) geeigneter Kapazität ist, einem Generator (10) zur Erzeugung einer frequenzvariablen Spannung (Ua) und einem Meßsystem (20) zur Erfassung der Güte von Spulen, **dadurch gekennzeichnet,** daß Mittel (50) zur automatischen Auswahl einer geeigneten Kapazität ($C_i$) im Reihenschwingkreis (1, 5), bei dem die Resonanzfrequenz ($f_{res}$) in einem solchen Bereich liegt, in dem die Spulengüte (Q) ihr Maximum hat, vorhanden sind.

**10.** Vorrichtung nach Anspruch 9, **dadurch gekennzeichnet,** daß das Meßsystem (20) kapazitätsarm an den Schwingkreis (1, 5) angekoppelt ist und daß mit dem Meßsystem (20) die Spannungsüberhöhung am Kondensator (5) des Schwingkreises (1, 5) gemessen wird.

**11.** Vorrichtung nach Anspruch 9, **dadurch gekennzeichnet,** daß an den Schwingkreis jeweils ein für den maximalen Gütewert der Spule geeigneter Kondensator (5) anschaltbar ist.

**12.** Vorrichtung nach Anspruch 9, **dadurch gekennzeichnet,** daß der Generator (10) zur Frequenzerzeugung niederohmig an den Schwingkreis (1, 5) angeschlossen ist.

**13.** Vorrichtung nach Anspruch 9, **dadurch gekennzeichnet,** daß dem Meßsystem (20) ein Personal-Computer (50) zur Ablaufsteuerung, Auswertung der Meßwerte und Anzeige der Ergebnisse zugeordnet ist.

**Claims**

**1.** Interturn and/or interlayer fault-testing method for coils, characterised by the following features:
- the coil (1) is connected as an inductor (2) and resistor (3) into a series resonant circuit (1, 5),
- the quality of the coil is measured by measuring the voltage overshoot given resonance of the resonant circuit,
- by selecting a suitable capacitance (5) in the series resonant circuit, the resonant frequency ($f_{res}$) is placed in such a range that the coil quality (Q) attains its maximum,
- the detected measured quality value of the coil is compared with a rated value and in the case of deviation from a predetermined tolerance value a signal is emitted for the interturn fault.

**2.** Method according to claim 1, characterised in that during the measurement the excitation frequency for the resonant circuit varies and the voltage is detected for this frequency in each case.

**3.** Method according to claim 1 or 2, characterised in that the optimum measuring frequency, which lies within a measuring frequency range dependent upon a test piece, is determined with the aid of a normal coil which approximates the test piece type.

**4.** Method according to claim 1 or 2, characterised in that the measuring frequency is varied and in each case the circuit quality is determined and in that the value of the quality is evaluated.

**5.** Method according to claim 3 and 4, characterised in that the detected measured quality value of the test piece is compared with a previously recorded quality of a normal coil and in the case of a deviation from a predetermined tolerance value a signal is emitted for the interturn fault.

**6.** Method according to claim 1, characterised in that in addition to the quality the interturn resistance of the coil is likewise measured.

**7.** Method according to claim 6, characterised in that the measured value of the quality is related to the interturn resistance.

**8.** Method according to claim 3, characterised in that the measuring frequency range is determined from a frequency spectrum of between approximately 500 Hz and approximately 100 kHz.

**9.** Arrangement for carrying out the interturn and/or interlayer fault-testing method according to claim 1 or one of the claims 2 to 8, having a series resonant circuit (1, 5) the component of which is the coil (test

7

piece 1) to be tested and a capacitor (5) of suitable capacitance, a generator (10) for generating a variable frequency voltage (Ua) and a measuring system (20) for determining the quality of coils, characterised in that means (50) are present for the automatic selection of a suitable capacitance ($C_i$) in the series resonant circuit (1, 5) in which the resonant frequency ($f_{res}$) lies within such a range that the coil quality (Q) has its maximum.

10. Arrangement according to claim 9, characterized in that the measuring system (20) is coupled with low capacitance to the resonant circuit (1, 5) and in that the voltage overshoot at the capacitor (5) of the resonant circuit (1, 5) is measured with the measuring system (20).

11. Arrangement according to claim 9, characterized in that a capacitor (5), which is suitable for the maximum quality value of the coil, can be connected to the resonant circuit in each case.

12. Arrangement according to claim 9, characterized in that the generator (10) for frequency generation is connected with low resistance to the resonant circuit (1, 5).

13. Arrangement according to claim 9, characterised in that a personal computer (50) for sequence-control, evaluation of the measured values and display of the results is associated with the measuring system (20).

**Revendications**

1. Procédé pour vérifier l'existence de courts-circuits entre des spires et/ou entre des couches de bobines, caractérisé par les caractéristiques suivantes :
   - on branche la bobine (1) en tant qu'inductance (2) et résistance (3) dans un circuit oscillant série (1,5),
   - on effectue une mesure du facteur de qualité de la bobine en mesurant l'augmentation de tension lorsque le circuit oscillant est à la résonance,
   - grâce au choix d'une capacité (5) appropriée dans le circuit oscillant série, on porte la fréquence de résonance ($f_{res}$) dans une plage, dans laquelle le facteur de qualité (Q) de la bobine atteint sa valeur maximale,
   - on compare la valeur de mesure du facteur de qualité de la bobine, qui a été détectée, à une valeur de consigne et, dans le cas où on s'écarte d'une valeur de tolérance pouvant être prédéterminée, on émet un signal indiquant un court-circuit entre des spires.

2. Procédé suivant la revendication 1, caractérisé par le fait que lors de la mesure, on modifie la fréquence d'excitation pour le circuit oscillant et on détecte la tension, à cette fréquence.

3. Procédé suivant la revendication 1 ou 2, caractérisé par le fait que l'on détermine la fréquence optimale de mesure, qui est dans une gamme de fréquences de mesure qui dépend de l'objet à tester, à l'aide d'une bobine normale, qui se rapproche du type de l'objet à tester.

4. Procédé suivant la revendication 1 ou 2, caractérisé par le fait qu'on modifie la fréquence de mesure, qu'on détermine le facteur de qualité du circuit et qu'on évalue la valeur du facteur de qualité.

5. Procédé suivant les revendications 3 et 4, caractérisé par le fait que l'on compare la valeur de mesure détectée du facteur de qualité de l'objet à tester à la valeur d'un facteur de qualité, enregistrée au préalable, d'une bobine normale et que, dans le cas d'un écart par rapport à une valeur de tolérance pouvant être prédéterminée, on fournit un signal indiquant le court-circuit entre des spires.

6. Procédé suivant la revendication 1, caractérisé par le fait qu'outre le facteur de qualité, on mesure également la résistance de la spire de la bobine.

7. Procédé suivant la revendication 6, caractérisé par le fait que l'on rapporte la valeur de mesure du facteur de qualité à la résistance de la spire.

8. Procédé suivant la revendication 3, caractérisé par le fait que l'on détermine la gamme des fréquences de mesure à partir d'un spectre de fréquences compris entre environ 500 Hz et environ 100 Hz.

8

**9.** Dispositif pour la mise en oeuvre du procédé de contrôle de courts-circuits entre des spires et/ou entre des couches suivant la revendication 1 ou l'une des revendications 2 à 8, qui comporte un circuit oscillant série (1,5), dont les éléments constitutifs sont la bobine à contrôler (objet à tester 1) et un condensateur (5) ayant une capacité appropriée, un générateur (10) servant à produire une tension (Ua) à fréquence variable, et un système de mesure (20) destiné à détecter le facteur de qualité de bobines, caractérisé par le fait qu'il est prévu des moyens (50) de sélection automatique d'une capacité appropriée ($C_i$) dans le circuit oscillant série (1,5), dans lequel la fréquence de résonance ($f_{res}$) est dans une gamme dans laquelle le facteur de qualité (Q) de la bobine atteint son maximum.

**10.** Dispositif suivant la revendication 9, caractérisé par le fait que le système de mesure (20) est couplé, avec une faible capacité, au circuit oscillant (1,5) et que l'augmentation de la tension aux bornes du condensateur (5) du circuit oscillant (1,5) est mesuré à l'aide du système de mesure (20).

**11.** Dispositif suivant la revendication 9, caractérisé par le fait que respectivement un condensateur (5), approprié pour l'obtention de la valeur maximale du facteur de qualité de la bobine, peut être relié au circuit oscillant.

**12.** Dispositif suivant la revendication 9, caractérisé par le fait que le générateur (10) servant à produire la fréquence est relié au circuit oscillant (1,5), selon une liaison à faible valeur ohmique.

**13.** Dispositif suivant la revendication 9, caractérisé par le fait qu' au système de mesure (20) est associé un ordinateur personnel (50) servant à effectuer la commande d'exécution, l'évaluation des valeurs de mesure et l'affichage des résultats.

FIG 1

$U_a$

10

$U_a$

11

12

2

3

1

5

$U_c$

20

$U_a = U_c$

FIG 1

$Q = \dfrac{U_{c\ Max}}{U_o}$

32

$Q = g(f)$

$f_{opt}$

$f_{res}$

FIG 2

FIG 3

FIG 4

FIG 5

S — 100

C_1 — 101

f_res — 102

U_a (f_res) — 103

U_a / R speichern — 104

C_i = letzter Kondensator — 105

ja

nein

C_opt (U_Max) = Sollwert — 106

C_i+1 — 107

U_a , f_1 - f_2 speichern — 108

E — 109

FIG 6

13

```
        ┌─────────┐
        │    S    │─ 200
        └─────────┘
             │
    ┌─────────────────┐
    │    R messen     │─ 201
    └─────────────────┘
             │
    ┌─────────────────┐
    │   C schalten    │─ 202
    └─────────────────┘
             │
    ┌─────────────────┐
    │  U_Max messen   │─ 203
    └─────────────────┘
             │
    ┌─────────────────┐
    │   U_Max / R     │─ 204
    └─────────────────┘
             │
```

$U_{Max} < U_{soll}$ — 205

ja

nein

Windungs - schluß — 206

E — 207

**FIG 7**